# EUROPÄISCHE PATENTANMELDUNG

(11) **EP 2 144 284 A1**
(43) Veröffentlichungstag der Anmeldung: **13.01.2010**
(21) Anmeldenummer: 08012612.1
(22) Anmeldetag: 11.07.2008
(51) Int. Cl.: H01L 21/60

(54) **Verfahren zum Herstellen eines Anschlusskontaktes an einem Halbleiterbauelement für die Leistungselektronik und elektronisches Bauteil mit einem auf diese Weise an einem Halblei-terbauelement hergestellten Anschlusskontakt**

(71) Anmelder: Siemens Aktiengesellschaft, 80333 München (DE)
(72) Erfinder: Birner, Martin, 92242 Hirschau (DE); Wöllmer, Heinz, Dr., 92260 Ammerthal (DE)

(57) **Zusammenfassung**

Die Erfindung betrifft ein Verfahren zum Herstellen eines Anschlusskontaktes an einem Halbleiterbauelement für die Leistungselektronik.
Erfindungswesentlich ist, dass das Halbleiterbauelement (1) mittels Laserschweißen mit einem Kontaktelement (2) verschweißt wird.

## Beschreibung

Die Erfindung betrifft ein Verfahren zum Herstellen eines Anschlusskontaktes an einem Halbleiterbauelement für die Leistungselektronik sowie ein elektronisches Bauteil mit einem Halbleiterbauelement, das mit einem Anschlusskontakt versehen ist.

Halbleiterbauelemente für die Leistungselektronik sind in der Regel als flache Plättchen ausgebildet, die auf plattenförmigen Trägersubstraten angeordnet sind. Als Trägersubstrat werden häufig sogenannte DCB(Direct Copper Bonded)-Trägersubstrate verwendet, die aus einem keramischen Isolator bestehen, der auf einer Flachseite mit einer metallischen Schicht, in der Regel aus Kupfer, versehen ist. Die Halbleiterbauelemente werden mit einer ihrer Flachseiten auf die metallische Schicht des Trägersubstrates gelötet. Auf seiner gegenüberliegenden Flachseite muss das Halbleiterbauelement ebenfalls mit einem elektrischen Anschlusskontakt versehen werden, an dem ein hoher, durch das Halbleiterbauelement senkrecht zu seinen Flachseiten fließender Laststrom abgegriffen werden kann (Lastanschluss). Das Schalten beziehungsweise Steuern dieses Laststromes erfolgt über ein Gate- oder Steueranschluss am Halbleiterbauelement. Der Anschluss für den Laststrom (Lastanschluss) und der Anschluss für den Steuerstrom (Steueranschluss) sind dabei im Allgemein elektrisch voneinander getrennt.

Um große Lastströme bei möglichst geringer Verlustleistung am Übergang zwischen Halbleiterbauelement und Anschlusskontakt führen zu können, ist es notwendig, dass die Anschlusskontakte für den Laststrom einen möglichst geringen Übergangswiderstand zum Halbleiterbauelement haben, um die elektrische Verlustleistung am Übergang und damit die thermische Belastung des Halbleiterbauelements zu reduzieren.

Ein geringer Übergangswiderstand kann auf der dem DCB-Trägersubstrat zugewandten Flachseite des Halbleiterbauelementes realisiert werden, indem dieses flächig auf das metallisierte DCB-Trägerstubstrat aufgelötet wird. Zum Herstellen des Lastenanschlusses auf der dem DCB-Trägersubstrat gegenüberliegenden Flachseite des Halbleiterbauelementes sind im Stand der Technik verschiedene Verfahren bekannt. Bei dem aus der DE 197 19 703 A1 bekannten Leistungshalbleitermodul ist eine Bondverbindung mit einer Mehrzahl von mit dem Halbleiterbauelement kontaktierten Bonddrähten vorgesehen, die eine Verbindung mit einem massiven Anschlusselement herstellen. Aus der WO 03/030247 A2 ist eine alternative Technologie bekannt, bei der in einem ersten Schritt auf das Halbleiterbauelement eine Kunststofffolie auflaminiert wird, in die anschließend Öffnungen eingebracht werden, so dass bei einem nachfolgenden Beschichten mit einem elektrisch leitenden Material an diesen Öffnungen eine elektrische Kontaktierung hergestellt wird, die eine große Kontaktfläche aufweisen kann. Alternativ hierzu ist es auch bekannt, einen metallischen Anschlussbügel oder -stift direkt mit dem Halbleiterbauelement zu verlöten.

Auch für die Kontaktierung des Steueranschlusses (Gate-Kontaktierung) können prinzipiell die gleichen Anschlussarten verwendet werden, wobei die häufigste Art der Gate-Kontaktierung das Kontaktieren mit einem Bonddraht ist.

Der Erfindung liegt nun die Aufgabe zugrunde, ein Verfahren zum Herstellen eines Anschlusskontaktes an einer elektrischen Kontaktfläche eines auf einem Substrat angeordneten Halbleiterbauelements für die Leistungselektronik anzugeben, mit dem eine elektrische Verbindung zum Halbleiterbauelement möglich ist, deren hohe Stabilität eine hohe Stromtragfähigkeit und einen geringen Übergangswiderstand aufweist. Außerdem liegt der Erfindung die Aufgabe zugrunde, ein elektronisches Bauteil mit einem Halbleiterbauelement anzugeben, das einen auf diese Weise hergestellten Anschlusskontakt aufweist.

Diese Aufgabe wird durch ein Verfahren mit den Merkmalen des Patentanspruchs 1 gelöst. Vorteilhafte Aus- und Weiterbildungen, welche einzeln oder in Kombination eingesetzt werden können, sind der Gegenstand der abhängigen Ansprüche.

Erfindungsgemäß wird diese Aufgabe durch ein Verfahren zum Herstellen eines Anschlusskontaktes am Halbleiterbauelement für die Leistungselektronik gelöst, wobei das Halbleiterbauelement mittels Laserschweißen mit einem Kontaktelement verschweißt wird. Das Laserschweißen wird vor Allem zum Verschweißen von Bauteilen eingesetzt, die mit hoher Schweißgeschwindigkeit, schmaler und schlanker Schweißnahtform und mit geringem thermischem Verzug gefügt werden müssen. Das Laserschweißen wird in der Regel ohne Zuführung eines Zusatzwerkstoffes ausgeführt. Die Laserstrahlung wird mittels einer Optik fokussiert. Die Werkstückoberfläche der Stoßkante, beziehungsweise der Fügestoß der zu verschweißenden Bauteile befindet sich in der unmittelbaren Nähe des Fokus der Optik, das heißt also im Brennfleck. Die Lage des Fokus relativ zur Werkstückoberfläche (oberhalb oder unterhalb) ist ein wichtiger Schweißparameter und legt zum Beispiel auch die Einschweißtiefe fest. Der Brennfleck besitzt typische Durchmesser von einigen Zehntelmillimetern, wodurch sehr hohe Energiekonzentrationen entstehen, wenn der eingesetzte Laser die typischen Leistungen von einigen KW-Laserleistungen besitzt. Durch Absorption der Laserleistung erfolgt auf der Werkstückoberfläche ein extrem schneller Anstieg der Temperatur über die Schmelztemperatur von Metall hinaus, so dass sich eine Schmelze bildet. Durch die hohe Abkühlgeschwindigkeit der Schweißnaht wird diese je nach Werkstoff sehr hart und verliert in der Regel an Zähigkeit. Beim Laserschweißen wird zwischen Lasertiefschweißen und Wärmeleitungsschweißen unterschieden. Beide Verfahren unterscheiden sich hauptsächlich durch die verwendeten Strahlintensitäten. Bei hohen Strahlintensitäten im Fokus bildet sich in der Schmelze in Strahlrichtung eine Dampfkapillare in der Tiefe des Werkstückes aus. Der Werkstoff wird dadurch auch in der Tiefe aufgeschmolzen, die Schmelzzone kann tiefer als breit sein. Die Dampfkapillare erhöht auf Grund von Mehrfachreflexion an den Wandungen die Absorption der Laserstrahlung im Material, wodurch ein gegenüber dem Wärmeleitungsschweißen vergrößertes Schmelzvolumen erzeugt werden kann. Werden Strahlintensitäten bis 100 KW/pro cm² verwendet, liegt in der Regel Wärmeleitschweißen vor. Da Metalle für Laserstrahlen, abhängig von der angestrahlten Wellenlänge eine Reflektivität von bis zu 95% besitzen können, reicht die Intensität nicht aus, um eine Dampfkapillare zu erzeugen. Die Strahlung dringt nicht ein, die Wärme und somit das Schmelzbad dringen weniger tief ein, daher werden hier mit hauptsächlich geringen Materialdicken geschweißt. Ein großer Vorteil lasergeschweißter Bauteile ist der durch den im Vergleich zu anderen Schweißverfahren geringere, konzentrierte Energieeintrag in das Werkstück. Die Folge ist unter Anderem geringerer thermisch bedingter Verzug. Daher wird dieses Schweißverfahren oftmals zum Fügen von Komponenten zu Fertigbauteilen eingesetzt. Damit wird oft auch der Nachteil der geringen Strahlungsabsorption beim Wärmeleitschweißen von Metallen ausgewogen. Ein weiterer Vorteil ist die große Arbeitsentfernung (Schweißen über bis etwa 500 mm Abstand oder an schwer zugänglichen Stellen) und die freie Wahl der Umgebungsatmosphäre. Besonderheit des Laserschweißens ist, dass sämtliche Nahtgeometrien hergestellt werden können.

Da im vorliegenden Fall der Anschlusskontakt durch ein unmittelbar mit dem Halbleiterbauelement stoffschlüssig verbundenes massives metallisches Kontaktelement erfolgt, ergibt sich eine besonders platzsparende Bauweise. Darüber hinaus ist eine hohe Strombelastbarkeit möglich, da durch das metallische Kontaktelement eine große Kontaktfläche und somit auch ein geringer Übergangswiderstand realisiert werden kann. Außerdem kann über das metallische Kontaktelement, das vorzugsweise aus Kupfer besteht, die im Halbleiterbauelement erzeugte Wärme besser abgeführt werden. Ein weiterer Vorteil besteht darin, dass es sich beim Laserschweißverfahren um ein Fertigungsverfahren handelt, das rationell und kostengünstig durchgeführt werden kann.

Unter unmittelbarer stoffschlüssiger Verbindung im Sinne der vorliegenden Anmeldung ist auch eine Ausführungsform zu verstehen, bei der das Halbleiterbauelement an seiner zu kontaktierenden Flachseite vor dem Herstellen der Laserschweißverbindung mit dem Kontaktelement eine dünne, als Kontaktfläche dienende metallische Kontaktschicht aufweist.

Das Halbleiterbauelement ist vorzugsweise ein Halbleiterchip, der als flaches Plättchen ausgebildet ist. Die Chipoberfläche weist eine schweißbare Metallschicht auf. Diese Schicht ist vorzugsweise aus Kupfer und von ausreichender Dicke, um eine intensive Laserschweißung zu ermöglichen. Auf die Metallschicht werden Kontaktteile aus Metall mittels Laserschweißens aufgeschweißt. Vorzugsweise werden hierfür Bleche oder Drähte aus Kupfer oder Kupferlegierung verwendet. Diese Kontaktteile können mit einer Oberflächenbeschichtung vorzugsweise aus Zinn oder Nickel beschichtet sein. Durch den Einsatz mehrerer Kontaktteile können unterschiedliche Stellen auf dem Halbleiterchip verbunden werden, zum Beispiel Lastanschluss und Gateanschluss. Die schweißbare Metallschicht ist vorzugsweise hergestellt durch galvanische oder stromlose Metallabscheidung oder zum Beispiel durch Auflöten eines Blechteils. Die Struktur der Schicht ist vorzugsweise so gestaltet, dass eine getrennte Kontaktierung von Gateanschluss und Lastanschluss der Oberseite möglich ist.

Als Trägersubstrate werden häufig sogenannte DCB-Trägersubstrate verwendet, die aus einem keramischen Isolator bestehen, der auf einer Flachseite mit einer metallischen Schicht, in der Regel aus Kupfer, versehen ist. Die Halbleiterbauelemente werden mit einer ihrer Flachseite auf die metallische Schicht des Trägersubstrats gelötet, gesintert oder geklebt.

Durch das Laserschweißen ist eine gut leitfähige Verbindung mit dem Chip möglich. Kontaktteile mit hohen Querschnitten aus gut elektrisch leitfähigen Kupferwerkstoffen können direkt an den Chip herangeführt und mit diesem verbunden werden. Das Laserschweißen ermöglicht eine stoffschlüssige Verbindung mit hoher mechanischer Festigkeit oder Leitfähigkeit. Durch den Einsatz großflächiger Kontaktteile mit vielen Schweißpunkten beziehungsweise großen Nahtlängen, wird eine großflächige Stromeinleitung und Wärmeabfuhr am Halbleiterchip ermöglicht. Die Stromtragfähigkeit des Schaltungsaufbaus wird erhöht. Das Laserschweißen ist auch anwendbar, wenn die Zugänglichkeit an die Fügestellen erschwert ist, weil die Schaltplatine bereits in ein Gehäuse montiert wurde.

Weitere Vorteile und Ausführungen der Erfindung werden nachfolgend anhand eines Ausführungsbeispiels sowie anhand einer Zeichnung erläutert.

Dabei zeigt schematisch:

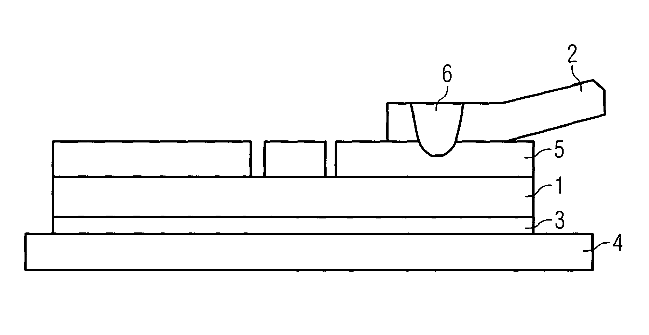

- Fig. 1: eine Schnittdarstellung eines erfindungsgemäßen Anschlusskontaktes zwischen einem Halbleiterbauelement und einem Kontaktelement

Fig. 1 zeigt eine Schnittdarstellung eines erfindungsgemäßen Anschlusskontaktes zwischen einem Halbleiterbauelement 1 und einem Kontaktelement 2. Das vorzugsweise plattenförmig ausgebildete Halbleiterbauelement 1 ist unterseitig über eine Verbindungsschicht 3 an einem Trägersubstrat 4 befestigt, wobei hierzu gelötet, geklebt oder gesintert werden kann. Oberseitig ist auf dem Halbleiterbauelement 1 eine schweißbare Metallschicht 5 angeordnet, an der das Kontaktelement 2 über eine Laserschweißverbindung 6 angeschweißt wird.

Das erfindungsgemäße Verfahren zum Herstellen eines Anschlusskontaktes an einer elektrischen Kontaktfläche eines auf einem Substrat angeordneten Halbleiterbauelementes für die Leistungselektronik ermöglicht eine elektrische Verbindung zum Halbleiterbauelement, deren hohe Stabilität eine hohe Stromtragfähigkeit und einen geringen Übergangswiderstand aufweist.

## Patentansprüche

1. Verfahren zum Herstellen eines Anschlusskontaktes an einem Halbleierbauelement (1) für die Leistungselektronik, **dadurch gekennzeichnet, dass** das Halbleiterbauelement (1) mittels Laserschweißen mit einem Kontaktelement (2) verschweißt wird.

2. Verfahren nach Anspruch 1, **dadurch gekennzeichnet, dass** das Halbleiterbauelement (1) über eine Verbindungsschicht (3) auf einem Substrat (4) aufgelötet wird.

3. Verfahren nach Anspruch 1, **dadurch gekennzeichnet, dass** das Halbleiterbauelement (1) unterseitig über eine Verbindungsschicht (3) auf einem Substrat (4) gesintert wird.

4. Verfahren nach Anspruch 1, **dadurch gekennzeichnet, dass** das Halbleiterbauelement (1) über eine Verbindungsschicht (3) auf einem Substrat (4) geklebt wird.

5. Verfahren nach einem der vorhergehenden Ansprüche, **dadurch gekennzeichnet, dass** das Halbleiterbauelement (1) oberseitig über eine schweißbare Metallschicht (5) mit dem Kontaktelement (2) durch eine Laserschweißverbindung (6) kontaktiert wird.

6. Verfahren nach einem der vorhergehenden Ansprüche, **dadurch gekennzeichnet, dass** als Substrat (4) ein DCB-Trägersubstrat verwendet wird.

7. Elektrisches Bauteil mit einem Halbleiterbauelement, **dadurch gekennzeichnet, dass** das Halbleiterbauelement (1) mittels Laserschweißen mit einem Kontaktelement (2) verschweißt ist.
